# EUROPEAN PATENT APPLICATION

(11) **EP 1 220 590 A1**
(43) Date of publication of application: **03.07.2002**
(21) Application number: 00830846.2
(22) Date of filing: 22.12.2000
(51) Int. Cl.: H05K 3/46

(54) **A process for making multilayered cards for printed circuits**

(71) Applicant: TAPEMATIC S.p.A., I-20052 Monza (Milano) (IT)
(72) Inventor: Perego, Luciano, 20050 Mezzago (MI) (IT); Ferri, Carlo, 21040 Carnago (VA) (IT)
(74) Representative: Tansini, Elio Fabrizio

(57) **Abstract**

A process for making multilayered cards for printed circuits involves setting down of a first conductive layer (2) carrying one or more conductive paths (2a) on a rest surface (7) of an assembling station (6) and setting down of a non-conductive intermediate layer (5a) on the first conductive layer (2). Subsequently, a second conductive layer (2) is superposed on the first conductive layer (2) located in the assembling station (6) and set down thereon, upon mutual collimation of the optical references arranged on the first and second conductive layers (2, 3). Once collimation has occurred, the second conductive layer (3) is fastened by heat sealing to the first conductive layer (2), before carrying out application of a new intermediate layer (5b) and a new conductive layer (4).

## Description

The present invention relates to a process for making multilayered cards for printed circuits comprising the steps set out in the preamble of claim 1.

The present invention pertains to the electronics sector, and in particular to production of printed circuits commonly used on computers, telephone sets and/or electronic apparatus of various kinds.

It is known that multilayered cards for printed circuits are presently made following processes requiring a great number of manual operations. Initially, each layer forming the card to be made exhibits a surface covered with a film of conductive material that, through a photoengraving process, is partly removed to define electric-connection lines or conductive paths disposed in a predetermined circuit diagram.

In addition to making conductive paths, photoengraving is also used to define inscriptions, symbols and/or recognition codes for each layer, as well as optical references having a precise and predetermined positioning relative to the conductive paths, necessary for carrying out the subsequent steps.

After the photoengraving operation, each conductive layer is individually submitted to a drilling operation consisting in forming one or more through holes at a predetermined position with respect to said optical references.

The drilling step is carried out by an operator with the aid of a punch provided with an appropriate luminous pointing system. In more detail, the operator determines collimation between the rays emitted by the luminous pointing system and the optical references present on the layer being worked thereby establishing, in a precise and identical manner for each layer of the card, the locations for the holes to be executed. Subsequently, each layer is transferred to an assembling station at which a support plate is arranged which is equipped with dowel pins positioning of which corresponds to that of the holes formed in each conductive layer. In this station, the operator puts the first conductive layer in place in such a manner that the holes of the latter match with the respective dowel pins of the support plate so that the first conductive layer is free to run along the dowel pins until the underlying support plate is reached. This operation is repeated for each layer to be assembled, upon interposition of an intermediate non-conductive layer, called "pre-preg".

When stacking of the layers forming the card is completed, said layers are vertically aligned and ready to be provisionally fastened to each other, usually by a rivetting operation.

After riveting, the card thus formed is taken off the dowel pins and put in a press or similar device, wherein mutual final fastening of the card layers takes place by effect of a combined heating and pressure action causing fusion of the intermediate non conductive or "pre-preg" layers and sealing of the same with the conductive layer.

The Applicant has found that known processes for making multilayered cards for printed circuits are susceptible of improvement under different points of view, mainly in connection with automation of the whole process and reduction of the production times and costs, while at the same time exonerating the operators from carrying out alienating and repetitive operations that, if they are not executed with the due care and attention, give rise to construction defects that can be only detected when the card is finished, thereby bringing about important charges in terms of discarded products. It is an object of the present invention to solve the problems found in the known art by providing a process for making multilayered cards for printed circuits which is automated, reliable, quick and cheap.

The foregoing and further objects that will become more apparent in the course of the following description are substantially achieved by a process for making multilayered cards for printed circuits comprising the features recited in the characterizing part of claim 1.

Further features and advantages will best be understood from the detailed description of a preferred but not exclusive embodiment of a process for making multilayered cards for printed circuits in accordance with the present invention. This description will be taken hereinafter with reference to the accompanying drawings, given by way of non-limiting example, in which:
- Fig. 1 is an exploded diagrammatic perspective view of a multilayered card for printed circuits;
- Fig. 2 is a diagrammatic plan view of a first conductive layer of the card in Fig. 1 during the step of laying it down in an assembling station;
- Fig. 3 is a diagrammatic plan view of a second conductive layer of the card in Fig. 1 during the step of transferring it to the assembling station and aligning it with the conductive layer shown in Fig. 2;
- Fig. 4 is a diagrammatic plan view of the conductive layers during the alignment step;
- Fig. 5 is a diagrammatic plan view of the conductive layers during the fastening step.

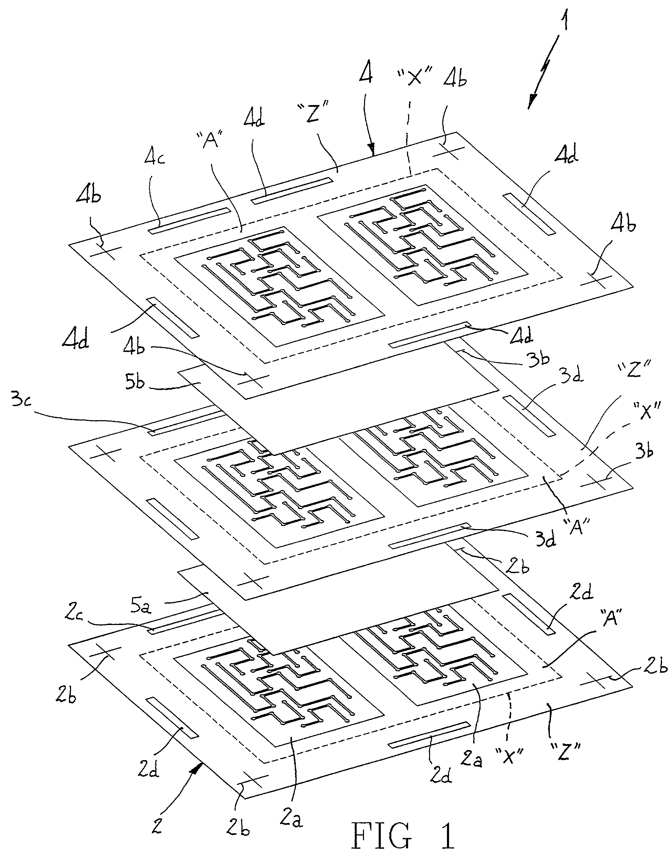

Referring particularly to Fig. 1, a multilayered card for printed circuits to be made with the subject process has been generally identified by reference numeral 1. Card 1 is made up of a plurality of conductive layers 2, 3, 4 and a plurality of intermediate non-conductive layers 5a, 5b referred to in the particular field as "pre-preg" layers. The conductive layers 2, 3, 4 are usually in the form of a sheet and initially have at least one surface covered with a film of conductive, preferably photosensitive, material. Depending on requirements however, both surfaces of the conductive layers 2, 3, 4 may be covered with said material.

As viewed from Fig. 1, each intermediate layer 5a, 5b, in the form of a sheet as well, is preferably interposed between a pair of conductive layers 2, 3, 4.

Each conductive layer 2, 3, 4 has an operating surface portion "A", preferably located at a central region of same, and a recognition surface portion "Z" preferably located at a peripheral region thereof circumscribing the operating surface portion "A". In the accompanying figures, the operating surface portion "A" and recognition surface portion "Z" of each conductive layer 2, 3, 4 are confined by a common boundary chain line "X".

First, preparation of each conductive layer 2, 3, 4 takes place, depending on the technical features of the card 1 to be made. Preparation of each conductive layer 2, 3, 4 consists in making one or more conductive paths 2a, 3a, 4a placed within the operating surface portion "A" and one or more optical references 2b, 3b, 4b placed within the recognition surface portion "Z". Also formed during the preparation of each conductive layer 2, 3, r 4, at the recognition surface portion "Z", may be one or more identification areas 2c, 3c, 4c, reproducing inscriptions or codes in alphameric characters and/or possible other symbols intended for identifying each conductive layer 2, 3, 4.

In accordance with a further aspect of the invention, preferably defined in the recognition surface portion "Z" of each conductive layer ", 3, 4, is one or more conductive heat-seal tracks 2d, 3d, 4d.

Advantageously, the conductive paths 2a, 3a, 4a, optical references 2b, 3b, 4b, inscriptions 2c, 3c, 4c and heat-seal tracks 2d, 3d, 4d are made simultaneously and in a single operation, carried out during preparation of each conductive layer 2, 3, 4, by a photoengraving process causing removal of the undesired conductive material from the corresponding surface of the conductive layer 2, 3, 4.

The conductive layers 2, 3, 4 treated by photoengraving or another suitable process and the intermediate layers 5a, 5b are stored in respective loading stations (not shown), provided close to an assembling station 6 at which layers 2, 3, 4, 5a, 5b are joined together and provisionally fastened to each other.

More specifically, a first conductive layer 2 is picked up from the respective loading station by a first grasping member (not shown) moving between the loading station itself and the assembling station. This first grasping member may advantageously comprise a sucking plate provided with a plurality of small holes distributed on a grasping surface thereof and communicating with a chamber defined within the plate itself, in which a sucking effect is produced. By appropriate actuating means, the sucking plate is brought to adhere, with its grasping surface, to the layer 2 to be picked up, so as to hold it fast by taking air in through said holes.

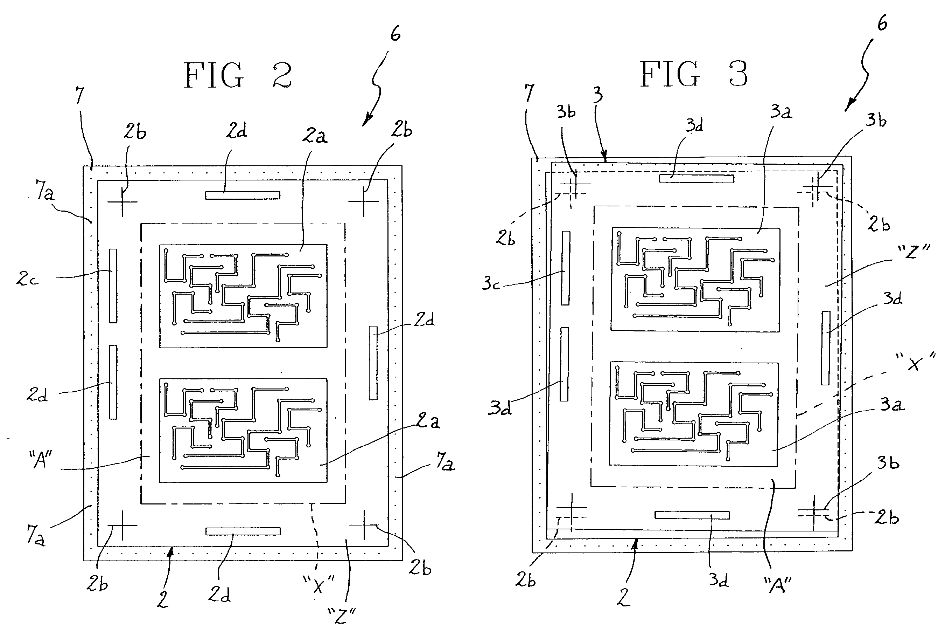

Subsequently, the first conductive layer 2 is transferred to the assembling station 6 where it is set down and positioned onto a preferably horizontal rest surface 7 (Fig. 2). The rest surface 7 of the assembling station 6 is made in the same manner as the sucking grasping plate. In more detail, the rest surface 7 has, on a support face thereof facing upwardly, a plurality of holes 7a through which air is taken in to ensure retention of the first conductive layer 2 positioned in the assembling station 6.

Afterwards, a first intermediate layer 5a is picked up from the respective loading station by said sucking plate or other grasping member to be transferred and laid down on the conductive layer 2 in superposed relationship therewith.

In order to optimize and speed up the picking up, transferring and deposit operations, use of two grasping members may be provided, i.e. a first grasping member intended to operate on the conductive layers 2, 3, 4 and a second grasping member intended to operate on the intermediate layers 5a, 5b. In this case while the first grasping member carries out positioning of the conductive layer 2, 3, 4 in the assembling station 6, the second grasping member carries out picking up and transferring to the assembling station 6 of the intermediate layer 5a, 5b to be set down. When the first grasping member is brought back again to the loading station of the conductive layers 2, 3, 4 to execute a further picking up operation, the second grasping member carries out deposit of the previously picked up intermediate layer 5a, 5b.

Following deposit of the first intermediate layer 5a, a second conductive layer 3 previously picked up from the respective loading station is transferred to the assembling station 6 (Fig. 3).

It is very likely that, as highlighted in Fig. 3, when the first grasping member stops in the assembling station 6 at the end of the transferring step, the conductive paths 3a carried by the second conductive layer 3 are not perfectly in register with the conductive paths 2a arranged in the first conductive layer 2 retained on the rest surface 7. Misalignment may be due to different reasons, such as inaccuracy in the positioning of layers 2, 3, 4 in the apparatus for carrying out the photoengraving process, inaccuracy in positioning the conductive layers 2, 3, 4 in the loading stations or inaccuracy in the stop position of the grasping member during the step of picking up and/or setting down the conductive layers 2, 3, 4, and still other reasons. Alignment between the conductive paths 2a, 3a of the two conductive layers 2, 3 by collimation of the respective optical references 2b, 3b is therefore required. This operation is advantageously carried out in the absence of mechanical alignment members such as pins or the like, with the aid of one or more optical detectors, such as video cameras or other similar apparatus arranged in the assembling station 6 and not shown as they can be made in any convenient manner.

In more detail, for the purpose of accomplishing alignment between the first and second conductive layers 2, 3 it is provided that following positioning of the first conductive layer 2, detection of the position of the optical references 2b of the latter should be carried out and subsequently stored in an appropriate data acquisition unit (not shown) operatively connected with the video cameras.

Following transferring of the second conductive layer 3 to the assembling station 6, when the second layer is still retained in a fixed location by the first grasping member, the position of the optical references 3b of the second conductive layer 3 is first detected and subsequently stored and compared with the position of the optical references 2b of the first conductive layer 2. By the above comparison diverging of each optical reference 3b of the second conductive layer 3 from the corresponding optical reference 2b of the first conductive layer 2 is detected. Said deviation may be for example expressed and stored in the form of linear values on Cartesian axes.

Based on the detected deviations, then a relative movement between the first and second conductive layers 2, 3 is carried out to cause collimation between the respective optical references 2b, 3b.

Preferably, collimation is carried out through movement of the rest surface 7 of the assembling station 6 and consequent displacement of the first conductive layer 2 relative to the second conductive layer 3.

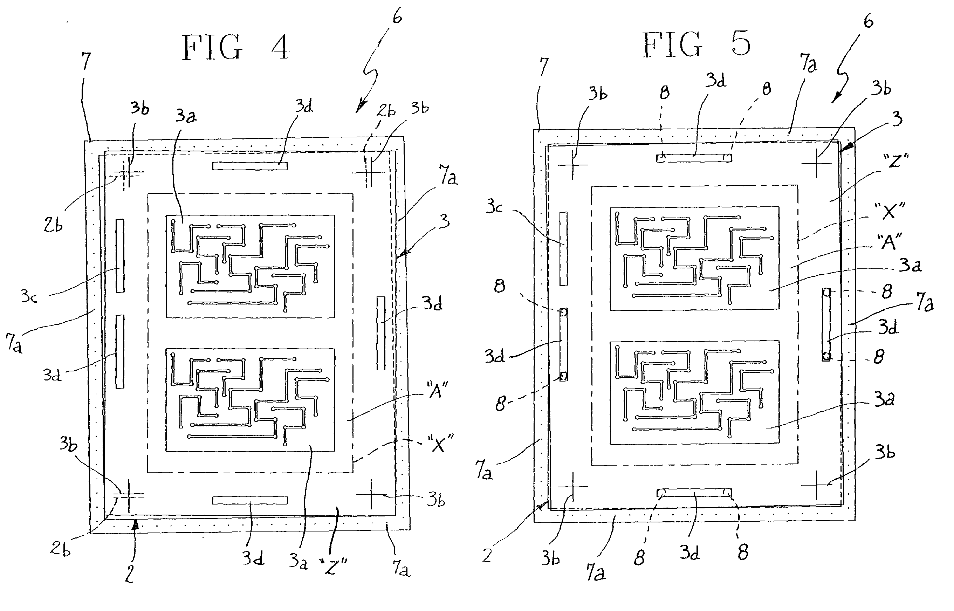

In more detail, it may be advantageously provided that, through movements of the rest surface 7 in two axes perpendicular to a plane parallel to the conductive layers 2, 3, one of the optical references 2b of the first conductive layer is first brought in register with the corresponding optical reference 3b of the second conductive layer 3, as shown in Fig. 4. Then collimation of the other optical references 2b, 3b can be carried out by a rotation movement of the rest surface 7 around an axis perpendicular to the conductive layers 2, 3 and passing through the centre of the already aligned optical references 2b, 3b.

When collimation has been completed, the second conductive layer 3 is set down on the first conductive layer 2 by making it rest on the first intermediate layer 5a.

Subsequently, the first conductive layer 2, first intermediate layer 5a and second conductive layer 3 are fastened together preferably by a heat-sealing operation (Fig. 5). In detail, heat-sealing is executed when the second conductive layer 3 is still retained by the first grasping member, by bringing a pair of electrodes 8 into direct contact with each conductive seal track 3d of the second conductive layer 3, simultaneously giving rise to a passage of electric current from an electrode to another as well as a thrust directed towards the rest surface 7. Each conductive seal track is consequently subjected to heating causing a partial localized fusion of the superposed layers 2, 3. In addition, the thrust exerted by each pair of electrodes 8 ensures an integral union between the concerned conductive layers 2, 3, when cooling takes place.

When heat sealing has been completed, the first grasping member is disengaged from the second conductive layer 3 and a second intermediate layer 5b previously picked up from the respective loading station is set down on the second conductive layer itself, while a third conductive layer 4 is being picked up to be subsequently transferred to the assembling station 6. A further alignment operation, similar to the one carried out for the first and second conductive layers 2, 3 is again accomplished for the purpose of collimating the optical references 3b, 4b of the second and third conductive layers 3, 4.

More particularly, for the purpose, detection of the position of the optical references 4b of the third conductive layer 4 is carried out and is then compared with the position of the optical references 2b, 3b of the second and first conductive layers 2, 3 previously stored so as to accomplish alignment. When the operation is over, the third conductive layer 4 is laid down as well so that it rests on the second intermediate layer 5b to be subsequently fastened to the second conductive layer by heat sealing, in the same manner as stated for fastening of the second conductive layer to the first one 2.

Obviously, once fastening of the third conductive layer 4 has been completed, further conductive layers can be added, upon interposition of the respective non conductive intermediate layers. Every operation involving alignment and setting down of a conductive layer is followed by an operation for fastening the latter to the already set down layers.

Once the last conductive layer has been heat sealed, the card 1 thus formed can be transferred from the assembling station 6 either to a storage station (not shown) or directly to other work stations at which, in known manner, the final mutual fixing of the conductive layers 2, 3, 4 is accomplished, by a combined heating and pressure action for example.

The process of the present invention solves the problems found in the known art and achieves the intended purposes. In fact, the whole process can be carried out in a completely automated manner, without requiring the operators' direct intervention.

In addition, automation of all the process steps gives rise to an important reduction in the number of the discarded cards which in the known art is usually due to errors or inaccuracies made by the operators.

It should be also recognized that automation enables an important production increase because, also due to the elimination of the intermediate punching steps required in the known art and executed on the individual layers, greatly reduced is the necessary time for manufacturing the cards, which will bring about a reduction in the production costs.

## Claims

1. A process for making multilayered cards for printed circuits comprising the following steps:
- forming at least one first and one second conductive layers (2, 3) each having at least one conductive path (2a, 2b) and at least one optical reference (2b, 3b);
- positioning said first conductive layer (2) in an assembling station (6);
- transferring said second conductive layer (3) to said assembling station (6);
- aligning the optical references (2b, 3b) of said first and said second conductive layers (2, 3);
- setting down said second conductive layer (3) in superposed relationship with said first conductive layer (2);
- fastening the first conductive layer (2) and the second conductive layer (3) together,
**characterized in that** alignment of the optical references (2b, 3b) of said conductive layers (2, 3) is carried out by use of at least one optical detector.

2. A process as claimed in claim 1, wherein alignment of the optical references (2b, 3b) of said first and second conductive layers (2, 3) takes place in the absence of mechanical alignment members.

3. A process as claimed in claim 1, further comprising the steps of:
- forming a third conductive layer (4) having at least one conductive path (4a) and at least one optical reference (4b);
- transferring said third conductive layer (4) to said assembling station (6);
- aligning the optical references (3b, 4b) of said second and said third conductive layers (3, 4);
- setting down said third conductive layer (4) in superposed relationship with said second conductive layer (3);
- fastening said third conductive layer (4) to said second conductive layer (3).

4. A process as claimed in claim 1, wherein alignment between the optical references (2b, 3b) of said first and second conductive layers (2, 3) comprises the following steps:
- detecting, by said optical detector, the position of the optical reference (2b) of said first conductive layer (2) subsequently to positioning of the latter in the assembling station (6);
- comparing the positions of the optical references (2b, 3b) of said first and second conductive layers (2, 3);
- operating a relative movement between said first and second conductive layers (2, 3) to collimate the respective optical references (2b, 3b) thereof.

5. A process as claimed in claim 4, wherein collimation between the optical references (2b, 3b) of said first and second conductive layers (2, 3) is carried out by moving said first conductive layer (2) relative to said second conductive layer (3).

6. A process as claimed in claim 5, wherein displacement of said first conductive layer (2) is carried out by moving a rest surface (7) of said assembling station (6) on which said first conductive layer (2) is set down.

7. A process as claimed in claim 1, wherein said first conductive layer (2) is held fast on a rest surface (7) of said assembling station (6) by a sucking action at least during accomplishment of the transfer and alignment steps.

8. A process as claimed in claim 7, wherein said first conductive layer (2) is held fast on said rest surface (6) during accomplishment of the steps of setting down and fastening said second conductive layer (2) onto said first conductive layer (3).

9. A process as claimed in claim 1, further comprising the steps of:
- preparing at least one non-conductive intermediate layer (5a, 5b);
- setting down said intermediate layer (5a, 5b) in superposed relationship with said first conductive layer (2) before carrying out the deposit step of the second conductive layer (3).

10. A process for making multilayered cards for printed circuits, in particular as claimed in claim 1, wherein said fastening step is carried out by a heat sealing operation.

11. A process as claimed in claim 10, wherein heat sealing is carried out by a passage of electric current along a conductive sealing track (3d) arranged on said second conductive layer (3) concurrently with a thrust action exerted on the conductive track itself.

12. A process as claimed in claim 10, wherein said conductive sealing track (3d) is made during the step of forming the second conductive layer (3), simultaneously with formation of the conductive paths (3a) on the same layer.

13. A process as claimed in claim 4, wherein transferring of each conductive layer (2, 3, 4) to said assembling station (6) is carried out by at least one first grasping member comprising a sucking plate.

14. A process as claimed in claim 9, wherein said at least one intermediate layer (5a, 5b) is transferred to the assembling station (6) by use of a second grasping member comprising a sucking plate, before carrying out the step of setting down the intermediate layer itself.
